Europäisches Patentamt

European Patent Office

Office européen des brevets

(19)

(11) Numéro de publication: **0 089 870**

**A1**

## (12) DEMANDE DE BREVET EUROPEEN

(21) Numéro de dépôt: **83400500.1**

(22) Date de dépôt: **11.03.83**

(51) Int. Cl.³: **H 03 H 9/36**

(30) Priorité: **19.03.82 FR 8204750**

(43) Date de publication de la demande:
**28.09.83 Bulletin 83/39**

(84) Etats contractants désignés:
**BE DE GB IT NL SE**

(71) Demandeur: **THOMSON-CSF**
**173, Boulevard Haussmann**
**F-75379 Paris Cedex 08(FR)**

(72) Inventeur: **Resneau, Jean-Claude**
**THOMSON-CSF SCPI 173, bld Haussmann**
**F-75379 Paris Cedex 08(FR)**

(72) Inventeur: **Puyhaubert, Jean**
**THOMSON-CSF SCPI 173, bld Haussmann**
**F-75379 Paris Cedex 08(FR)**

(72) Inventeur: **Jacquemin, Claude**
**THOMSON-CSF SCPI 173, bld Haussmann**
**F-75379 Paris Cedex 08(FR)**

(72) Inventeur: **Martin, Pascal**
**THOMSON-CSF SCPI 173, bld Haussmann**
**F-75379 Paris Cedex 08(FR)**

(54) Ligne à retard électro-acoustique du type transmission.

(57) L'invention concerne une ligne à retard électro-acoustique du type transmission.

Cette ligne comporte un support acoustique (3) délimité par une surface latérale cylindrique (5), et deux surfaces terminales focalisantes (7, 9) en forme de calottes sphériques, sur lesquelles sont fixés respectivement deux transducteurs (E, S) disposés de part et d'autre de l'axe longitudinal du support. Les deux calottes focalisantes sont inclinées par rapport à l'axe du support d'angles respectifs ($\alpha$, $\beta$) tels que l'onde acoustique incidente ($I_1$) subisse une seule réflexion sur la calotte d'entrée (7) et tels que l'onde acoustique réfléchie ($I_3$) vienne se concentrer au niveau du transducteur de sortie (S).

Application aux lignes à retard à ondes de volume et à un seul écho.

EP 0 089 870 A1

FIG_1

1

## LIGNE A RETARD ELECTRO-ACOUSTIQUE
## DU TYPE TRANSMISSION

La présente invention se rapporte d'une manière générale aux lignes à retard électro-acoustiques à ondes de volume ou à ondes de surface, et concerne plus particulièrement une ligne à retard hyperfréquence du type transmission.

De façon générale, une ligne à retard opérant en transmission, par exemple à onde de volume, comporte un support de propagation acoustique constitué par un matériau retardateur monocristallin, et deux transducteurs piézoélectriques transformant une onde électromagnétique en une onde acoustique et réciproquement, fixés soit respectivement sur deux faces terminales opposées du support acoustique, soit sur une même face terminale du support.

On connaît différentes structures de ligne à retard électro-acoustique du type transmission dont les deux transducteurs sont fixés respectivement sur deux faces terminales opposées du support acoustique. L'une d'entre elles consiste en un support acoustique délimité par une surface latérale cylindrique, et deux surfaces terminales en forme de calottes sphériques, respectivement d'entrée et de sortie, centrées sur l'axe de symétrie du cylindre et assurant une focalisation de l'onde acoustique. Les deux calottes sphériques ont des rayons de courbure identiques égaux au quadruple de la longueur du cylindre. De plus, les deux transducteurs piézoélectriques, respectivement d'entrée et de sortie, sont fixés symétriquement par rapport à l'axe du cylindre sur les calottes d'entrée et de sortie. Par une excitation du transducteur d'entrée à une fréquence hyperfréquence donnée, l'onde acoustique incidente subit une première réflexion sur la calotte focalisante de sortie, puis l'onde réfléchie vient se concentrer en un point de la calotte focalisante d'entrée situé sur l'axe du cylindre où elle se réfléchit à nouveau. Cette dernière onde réfléchie vient ensuite se concentrer au niveau du transducteur de sortie symétrique du transducteur d'entrée, et subit une seconde réflexion sur la calotte focalisante de sortie. Cette dernière onde réfléchie est ensuite focalisée sur la calotte d'entrée, l'onde acoustique ayant ainsi parcouru deux allers et retours dans le support. Par raison de symétrie, l'onde acoustique suit le trajet inverse de celui qui vient d'être décrit.

En tenant compte par exemple de deux allers et retours de l'onde acoustique dans le support, la ligne à retard décrite ci-dessus délivre un signal retardé à un écho, et dont le retard correspond à la durée de deux allers et d'un retour de l'onde acoustique dans le support, cette durée étant proportionnelle à la longueur du trajet de ladite onde dans le support acoustique.

Toutefois, une telle ligne à retard présente des inconvénients. En effet, pour un signal d'entrée hyperfréquence constitué par exemple par une impulsion, le signal de sortie engendré par la ligne comporte une première impulsion appelée fuite directe présentant une amplitude relativement élevée, cette fuite directe étant due au couplage entre les transducteurs d'entrée et de sortie, et son niveau élevé étant dû au fait que les transducteurs ne sont pas suffisamment éloignés l'un de l'autre. Cette première impulsion est suivie d'une seconde impulsion d'amplitude également élevée représentant un écho parasite dû à la première réflexion de l'onde acoustique incidente sur la calotte de sortie, le niveau élevé de cet écho parasite étant dû au fait que le transducteur de sortie n'est pas suffisamment éloigné du point d'impact de l'onde incidente sur ladite calotte de sortie. Cet écho parasite est suivi d'une troisième impulsion constituant le premier écho. Par raison de symétrie du trajet de l'onde acoustique, le signal de sortie comporte, après le premier écho, une autre impulsion constituant le second écho et précédant une impulsion représentant un écho parasite, et ainsi de suite.

La présente invention a pour but de remédier à ces inconvénients en proposant une ligne à retard électro-acoustique du type transmission, dont les deux transducteurs sont fixés respectivement sur deux faces terminales opposées du support acoustique, qui est simple à réaliser, délivre un signal retardé à un seul écho suivi d'aucun écho parasite en raison du trajet dissymétrique de l'onde acoustique, et permet d'obtenir à la fois un signal direct dû au couplage entre les deux transducteurs présentant une faible amplitude, et un écho parasite également de faible amplitude précédant le signal retardé.

A cet effet, l'invention a pour objet une ligne à retard électro-acoustique du type transmission, comportant :

- un support de propagation d'une onde acoustique, présentant un axe longitudinal, et délimité par au moins une surface latérale, une surface terminale d'entrée de révolution, une surface terminale de sortie de révolution, les surfaces d'entrée et de sortie assurant une focalisation de l'onde acoustique ;

- un transducteur d'entrée et un transducteur de sortie transformant une onde électromagnétique en onde acoustique et réciproquement, les transducteurs d'entrée et de sortie étant disposés respectivement sur les surfaces terminales d'entrée et de sortie et étant placés de part et d'autre de l'axe longitudinal du support ;

caractérisée en ce qu'au moins l'une des surfaces terminales d'entrée et de sortie est inclinée par rapport à l'axe longitudinal du support, et en ce que l'angle d'incidence formé par l'onde acoustique incidente engendrée par le transducteur d'entrée et l'axe de révolution de la surface terminale de sortie est tel que l'onde acoustique réfléchie par la surface terminale de sortie subisse une seule réflexion sur la surface terminale d'entrée et tel que l'onde acoustique réfléchie sur la surface terminale d'entrée vienne se concentrer au niveau du transducteur de sortie, permettant ainsi d'obtenir un signal retardé à un seul écho.

D'autres caractéristiques et avantages de l'invention apparaîtront mieux dans la description détaillée qui suit et se réfère aux dessins annexés, donnés uniquement à titre d'exemple, et dans lesquels :

4

- la figure 1 représente schématiquement une ligne à retard selon l'invention ; et

- la figure 2, a et b, représente respectivement en fonction du temps un signal d'entrée et sa réponse en sortie de la ligne à retard selon l'invention.

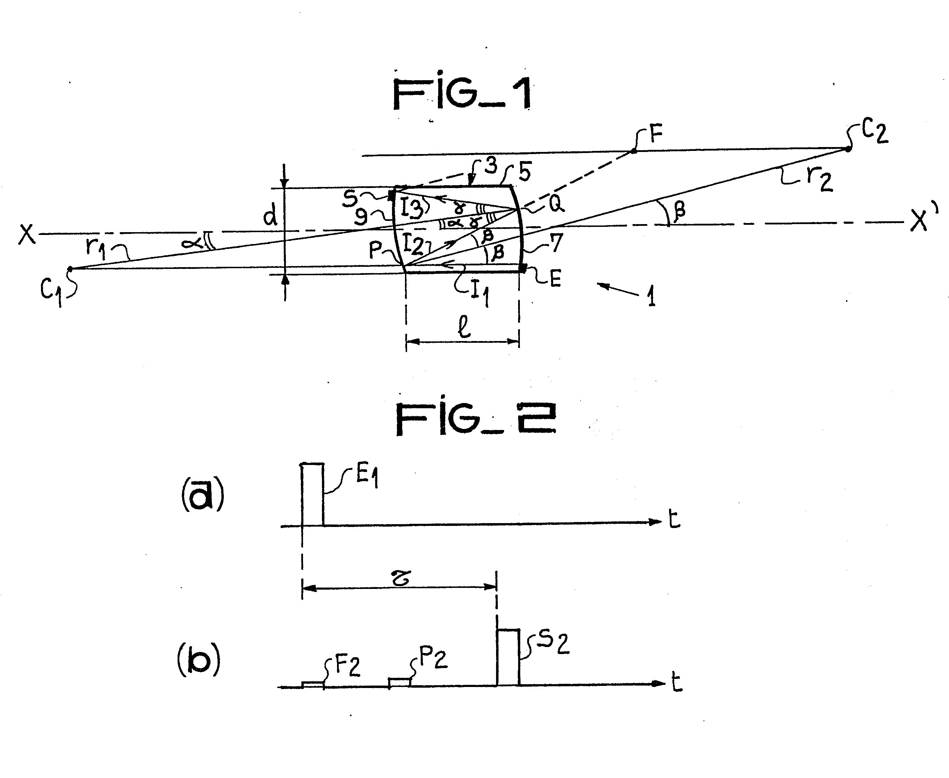

Selon un mode de réalisation préféré, représenté sur la figure 1, une ligne à retard 1 du type transmission, par exemple à onde de volume, conforme à l'invention, comporte un support ou milieu de propagation acoustique 3, constitué par un matériau retardateur, tel que par exemple du verre ou du corindon.

Le support 3 est délimité par une surface latérale par exemple cylindrique 5, d'axe de symétrie XX' constituant l'axe longitudinal du support, une surface terminale d'entrée de révolution, constituée par exemple par une calotte sphérique polie 7 sur laquelle est fixé un transducteur d'entrée E, et une surface terminale de sortie de révolution, constituée par exemple par une calotte sphérique polie 9 sur laquelle est fixé un transducteur de sortie S, les calottes 7 et 9 assurant une focalisation de l'onde acoustique.

Comme il apparaît sur la figure 1, les deux transducteurs E et S sont placés de part et d'autre de l'axe XX' du support 3, et sont chacun disposés près d'un bord de la surface latérale cylindrique 5 du support acoustique, de sorte que lesdits transducteurs sont éloignés l'un de l'autre, permettant ainsi de réduire l'intensité du signal transmis par couplage direct entre les transducteurs.

De préférence, l'onde acoustique incidente $I_1$ engendrée par le transducteur d'entrée E est parallèle à l'axe XX' du support 3, de sorte que le point d'impact P de l'onde incidente $I_1$ sur la calotte de sortie 9 se trouve éloigné du transducteur de sortie S, permettant ainsi de réduire le niveau de l'écho parasite dû à la réflexion de l'onde incidente audit point d'impact.

Les rayons de courbure respectifs $r_1$ et $r_2$ des calottes 7 et 9 sont identiques et sont de l'ordre du quadruple de la longueur donnée l de la surface latérale cylindrique 5 du support 3. On a représenté en d le diamètre de la surface latérale cylindrique 5.

5

Comme on le voit bien sur la figure 1, les calottes 7 et 9 sont décentrées par rapport à l'axe longitudinal XX' du support acoustique 3, c'est-à-dire qu'elles sont chacune inclinées d'un angle donné formé par l'axe XX' et leur axe de révolution passant par le centre de courbure. On a représenté en $\alpha$ l'angle d'inclinaison de la calotte d'entrée 7 de centre de courbure $C_1$, et en $\beta$ l'angle d'inclinaison de la calotte de sortie 9 de centre de courbure $C_2$.

L'angle $\alpha$ est choisi de telle sorte que le centre de courbure $C_1$ de la calotte d'entrée 7 soit situé sur la droite prolongeant l'onde acoustique incidente $I_1$ parallèle à l'axe XX', la droite passant par le centre de courbure $C_1$ et le transducteur d'entrée E étant ainsi parallèle à l'axe XX' du support acoustique 3. De plus, l'angle $\beta$ est choisi de telle sorte que la droite passant par le centre de courbure $C_2$ de la calotte de sortie 9 et le point focal F de ladite calotte 9 soit parallèle à l'axe XX' du support acoustique 3 et soit située à l'extérieur dudit support.

Ainsi, par cette construction, l'onde acoustique $I_1$, parallèle à l'axe XX' du support 3 et engendrée par le transducteur d'entrée E, ce dernier étant relié à un circuit d'excitation hyperfréquence (non représenté), se dirige sur la calotte de sortie 9 sous un angle d'incidence égal à l'angle d'inclinaison $\beta$ de la calotte 9, et se réfléchit en P sur la calotte 9 avec un angle de réflexion égal à l'angle d'inclinaison $\beta$. L'onde acoustique réfléchie $I_2$ se dirige ensuite sur la calotte d'entrée 7 sous un angle d'incidence $\gamma$ déterminé en fonction des angles d'inclinaison respectifs $\alpha$ et $\beta$ des calottes 7 et 9, de telle sorte que l'onde acoustique $I_3$ réfléchie en Q sur la calotte 7, avec un angle de réflexion égal à $\gamma$, vienne se concentrer au niveau du transducteur de sortie S situé près du bord de la surface latérale cylindrique 5 du support. Dès lors, l'onde acoustique réfléchie sur la calotte 9 au niveau du transducteur de sortie S vient se réfléchir sur la surface latérale 5 du support 3. On obtient ainsi, en sortie du transducteur S, un signal retardé à un seul écho.

Pour absorber l'onde acoustique se réfléchissant sur la surface latérale cylindrique 5, la ligne à retard comporte de plus des moyens d'absorption (non représentés) constitués par exemple par une couche de vernis déposée sur ladite surface latérale, de sorte que le signal retardé à un seul écho ainsi obtenu n'est suivi d'aucun écho parasite.

On notera que pour tout angle d'incidence donné de l'onde acoustique $I_1$, et différent de l'angle d'inclinaison $\beta$ de la calotte 9, les angles d'inclinaison respectifs $\alpha$ et $\beta$ des deux calottes sont déterminés de telle sorte que l'onde acoustique $I_2$ réfléchie sur la calotte 9 subisse une seule réflexion sur la calotte 7 et de telle sorte que l'onde acoustique $I_3$ réfléchie sur la calotte 7 avec l'angle de réflexion $\gamma$, dont la valeur est fonction de l'angle d'incidence donné et des angles d'inclinaison $\alpha$ et $\beta$, vienne se concentrer au niveau du transducteur de sortie S, l'onde acoustique réfléchie à nouveau sur la calotte 9 venant se réfléchir sur la surface latérale cylindrique 5 du support 3.

Bien entendu, le support acoustique peut être réalisé à partir d'un parallélépipède, et chaque calotte sphérique peut être remplacée par toute surface de révolution, telle que par exemple une portion de paraboloïde ou d'ellipsoïde, sans sortir du cadre de l'invention.

Ainsi, pour toute surface focalisante de révolution, l'angle d'inclinaison $\alpha$ ou $\beta$ est formé par l'axe longitudinal du support acoustique et l'axe de révolution de ladite surface focalisante.

Le diagramme 2a représente en fonction du temps $\underline{t}$ un signal d'entrée hyperfréquence, constitué par exemple par une impulsion $E_1$ de niveau donné.

Le diagramme 2b représente la réponse à ce signal impulsionnel $E_1$, obtenue en sortie de la ligne à retard de la figure 1.

Ce signal de sortie comporte une première impulsion $F_2$, de faible amplitude, représentant le couplage direct entre les deux transducteurs, une seconde impulsion $P_2$, également de faible amplitude, représentant l'écho parasite dû à la réflexion de l'onde incidente $I_1$ en P de la calotte de sortie 9 (figure 1), et une troisième impulsion $S_2$ représentant le signal retardé à un seul écho et suivi d'aucun écho parasite, le retard $\tau$ du signal $S_2$ étant proportionnel à la longueur du trajet de l'onde acoustique dans le support de propagation.

La ligne à retard selon l'invention a été décrite ci-dessus en se référant à un support acoustique dont les deux surfaces terminales de révolution sont inclinées par rapport à l'axe longitudinal du support. Bien entendu, la ligne à deux surfaces terminales focalisantes peut comporter une seule surface de révolution inclinée par rapport à l'axe du support acoustique, sans sortir du cadre de l'invention.

Ainsi, selon un autre mode de réalisation (non représenté), l'axe de révolution de la surface terminale de sortie est confondu avec l'axe longitudinal du support, l'onde acoustique engendrée par le transducteur d'entrée étant dirigée sur ladite surface terminale sous un angle d'incidence donné. Dans ce cas, la surface terminale d'entrée est inclinée par rapport à l'axe du support d'un angle tel que l'onde acoustique, après réflexion sur la surface de sortie, subisse une seule réflexion sur la surface d'entrée, et tel que l'onde acoustique réfléchie sur ladite surface d'entrée vienne se concentrer au niveau du transducteur de sortie, l'onde acoustique à nouveau réfléchie sur la surface de sortie au niveau du transducteur de sortie venant se réfléchir sur la surface latérale du support acoustique, de sorte que la ligne à retard engendre en sortie un signal retardé à un seul écho, suivi d'aucun écho parasite.

Selon encore un autre mode de réalisation (non représenté), l'axe de révolution de la surface terminale d'entrée est confondu avec l'axe longitudinal du support, l'onde acoustique engendrée par le transducteur d'entrée étant dirigée sur la surface terminale de sortie sous un angle d'incidence donné. Dans ce cas, la surface de sortie est inclinée par rapport à l'axe longitudinal du support d'un angle tel que l'onde acoustique, après réflexion sur la surface de sortie, subisse une seule réflexion sur la surface d'entrée, et tel que l'onde acoustique réfléchie sur ladite surface d'entrée vienne se concentrer au niveau du transducteur de sortie, l'onde acoustique à nouveau réfléchie sur la surface de sortie au niveau du transducteur de sortie venant se réfléchir sur la surface latérale du support acoustique, de sorte que la ligne engendre en sortie un signal retardé à un seul écho, suivi d'aucun écho parasite.

A titre illustratif, la Demanderesse a réalisé une ligne à retard du type transmission suivant le mode de réalisation représenté sur la figure 1, en utilisant un support acoustique cylindrique en corindon, de longueur $l = 37$ mm, de diamètre $d = 10$ mm, dont les deux surfaces terminales focalisantes sont des calottes sphériques inclinées toutes deux par rapport à l'axe du support, et de même rayon de courbure, avec $r_1 = r_2 = 148$ mm. Les deux transducteurs piézoélectriques sont distants l'un de l'autre d'une hauteur égale à 8 mm. L'angle d'inclinaison $\alpha$ de la calotte d'entrée est de l'ordre de 3° et l'angle d'inclinaison $\beta$ de la calotte de sortie est de l'ordre de 5°. Pour cette ligne, le retard mesuré est égal à 10 µs pour une fréquence de fonctionnement de l'ordre de 1 GHz. De plus, les pertes d'insertion engendrées par la ligne, c'est-à-dire l'atténuation du signal de sortie par rapport au signal d'entrée, sont de l'ordre de 25 dB.

9

## REVENDICATIONS

1. Ligne à retard électro-acoustique du type transmission, comportant :

-. un support (3) de propagation d'une onde acoustique, présentant un axe longitudinal (XX'), et délimité par au moins une surface latérale (5), une surface terminale d'entrée de révolution (7), une surface terminale de sortie de révolution (9), les surfaces d'entrée et de sortie assurant une focalisation de l'onde acoustique ;

– un transducteur d'entrée (E) et un transducteur de sortie (S) transformant une onde électromagnétique en onde acoustique et réciproquement, les transducteurs d'entrée (E) et de sortie (S) étant disposés respectivement sur les surfaces terminales d'entrée (7) et de sortie (9) et étant placés de part et d'autre de l'axe longitudinal du support ;

caractérisée en ce qu'au moins l'une des surfaces terminales d'entrée (7) et de sortie (9) est inclinée par rapport à l'axe longitudinal du support (3), et en ce que l'angle d'incidence formé par l'onde acoustique incidente engendrée par le transducteur d'entrée (E) et l'axe de révolution de la surface terminale de sortie est tel que l'onde acoustique réfléchie par la surface terminale de sortie subisse une seule réflexion sur la surface terminale d'entrée (7) et tel que l'onde acoustique réfléchie sur la surface terminale d'entrée vienne se concentrer au niveau du transducteur de sortie (S), permettant ainsi d'obtenir un signal retardé à un seul écho.

2. Ligne à retard selon la revendication 1, caractérisée en ce que l'axe de révolution de la surface terminale de sortie est confondu avec l'axe longitudinal du support, l'onde acoustique engendrée par le transducteur d'entrée étant dirigée sur la surface terminale de sortie sous l'angle d'incidence précité, et en ce que la surface terminale d'entrée est inclinée par rapport à l'axe longitudinal du support d'un angle tel que l'onde acoustique, après réflexion sur la surface terminale d'entrée, vienne se concentrer au niveau du transducteur de sortie, l'onde acoustique réfléchie sur la surface terminale de sortie au niveau du transducteur de sortie venant se réfléchir sur la surface latérale du support acoustique.

3. Ligne à retard selon la revendication 1, caractérisée en ce que l'axe de révolution de la surface terminale d'entrée est confondu avec l'axe longitudinal du support, l'onde acoustique engendrée par le transducteur d'entrée étant dirigée sur la surface terminale de sortie sous l'angle d'incidence précité, et en ce que la surface terminale de sortie est inclinée par rapport à l'axe longitudinal du support d'un angle tel que l'onde acoustique, après réflexion sur la surface terminale d'entrée, vienne se concentrer au niveau du transducteur de sortie, l'onde acoustique réfléchie sur la surface terminale de sortie au niveau du transducteur de sortie venant se réfléchir sur la surface latérale du support acoustique.

4. Ligne à retard selon la revendication 1, caractérisée en ce que les surfaces terminales d'entrée (7) et de sortie (9) sont chacune inclinées par rapport à l'axe longitudinal du support, l'onde acoustique engendrée par le transducteur d'entrée (E) étant dirigée sur la surface terminale de sortie sous l'angle d'incidence précité, et en ce que les angles d'inclinaison respectifs ( α, β ) des surfaces terminales d'entrée (7) et de sortie (9) sont tels que l'onde acoustique, après réflexion sur la surface terminale d'entrée (7), vienne se concentrer au niveau du transducteur de sortie (S), l'onde acoustique réfléchie sur la surface terminale de sortie au niveau du transducteur de sortie venant se réfléchir sur la surface latérale (5) du support acoustique.

5. Ligne à retard selon la revendication 4, caractérisée en ce que les transducteurs d'entrée (E) et de sortie (S) sont chacun disposés au voisinage d'un bord de la surface latérale (5) du support, et en ce que l'onde acoustique incidente engendrée par le transducteur d'entrée est parallèle à l'axe longitudinal (XX') du support,

11

l'angle d'inclinaison ( $\beta$ ) de la surface terminale de sortie (9) étant égal à l'angle d'incidence précité.

6. Ligne à retard selon la revendication 5, caractérisée en ce que les surfaces d'entrée (7) et de sortie (9) sont chacune constituées par une calotte sphérique, en ce que les rayons de courbure des deux calottes sont égaux, en ce que le centre de courbure $(C_1)$ de la calotte d'entrée est situé sur la droite prolongeant l'onde acoustique incidente $(I_1)$, et en ce que la droite passant par le centre de courbure $(C_2)$ de la calotte de sortie et le point focal (F) de ladite calotte de sortie est parallèle à l'axe longitudinal du support et est située à l'extérieur du support (3), de sorte que l'onde acoustique, après réflexion sur la calotte de sortie, est réfléchie sur la calotte d'entrée (7) et vient ensuite se concentrer au niveau du transducteur de sortie (S).

7. Ligne à retard selon la revendication 6, caractérisée en ce que la surface latérale (5) du support acoustique est de forme cylindrique dont l'axe de symétrie constitue l'axe longitudinal du support, et en ce que le rayon de courbure de chaque calotte sphérique est sensiblement égal au quadruple de la longueur (l) de la surface latérale cylindrique.

8. Ligne à retard selon l'une des revendications précédentes, caractérisée en ce qu'elle comporte de plus des moyens pour absorber l'onde acoustique se réfléchissant sur la surface terminale de sortie (9) au niveau du transducteur de sortie (S), ces moyens d'absorption étant disposés sur la surface latérale (5) du support acoustique, de sorte que le signal retardé à un seul écho n'est suivi d'aucun écho parasite.

9. Ligne à retard selon l'une des revendications précédentes, caractérisée en ce que l'onde acoustique incidente engendrée par le transducteur d'entrée (E) est une onde de volume.

12

10. Ligne à retard selon l'une des revendications précédentes, caractérisée en ce que les surfaces terminales d'entrée (7) et de sortie (9) sont polies.

# FIG_1

# FIG_2

(a)

(b)

1/1

0089870

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | FR-A-2 345 729 (LIGNES TELEGRAPHIQUES ET TELEPHONIQUES) * Figures 3-5; page 2, ligne 25 - page 3, ligne 35; page 7, ligne 34 - page 8, ligne 15 * | 1-4,6-8 | H 03 H 9/36 |
| | --- | | |
| A | FR-A-2 239 812 (LIGNES TELEGRAPHIQUES ET TELEPHONIQUES) * En entier * | 1-4,6,7 | |
| | ----- | | |

**DOMAINES TECHNIQUES RECHERCHES (Int. Cl. ³)**

H 03 H

Le présent rapport de recherche a été établi pour toutes les revendications

| Lieu de la recherche LA HAYE | Date d'achèvement de la recherche 28-06-1983 | Examinateur COPPIETERS C. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

OEB Form 1503. 03. 82